# EUROPÄISCHE PATENTSCHRIFT

(11) **EP 3 961 078 B1**
(45) Veröffentlichungstag und Bekanntmachung des Hinweises auf die Patenterteilung: **25.01.2023**
(21) Anmeldenummer: 20193157.3
(22) Anmeldetag: 27.08.2020
(51) Int. Cl.: F16L 19/028

(54) **VERFAHREN ZUR BESCHICHTUNG EINES SCHRAUBELEMENTES, SCHRAUBELEMENT UND ROHRANSCHLUSSEINRICHTUNG**
METHOD FOR COATING A SCREW ELEMENT, SCREW ELEMENT AND PIPE CONNECTION DEVICE
PROCÉDÉ DE REVÊTEMENT D'UN ÉLÉMENT À VIS, ÉLÉMENT À VIS ET DISPOSITIF RACCORD DE TUBE

(43) Veröffentlichungstag der Anmeldung: 02.03.2022
(73) Patentinhaber: TI Automotive (Heidelberg) GmbH, 69123 Heidelberg (DE)
(72) Erfinder: Stahn, Andreas, 69231 Rauenberg (DE); Weick, Georg, 68723 Plankstadt (DE)
(74) Vertreter: Andrejewski - Honke Patent- und Rechtsanwälte Partnerschaft mbB

(56) Entgegenhaltungen:
- EP-A1- 3 555 512
- EP-A2- 2 706 277
- US-A1- 2014 169 911

## Beschreibung

Die Erfindung betrifft ein Verfahren zur Beschichtung eines Schraubelementes, insbesondere eines Schraubelementes für den Anschluss von Rohrleitungen, vorzugsweise für den Anschluss von Kraftfahrzeugrohrleitungen, wobei das Schraubelement zumindest ein Gewinde aufweist sowie zumindest eine gewindefreie Kontaktfläche aufweist, wobei das Gewinde zumindest bereichsweise mit einer ersten Beschichtung versehen ist und wobei die gewindefreie Kontaktfläche zumindest bereichsweise mit einer zweiten Beschichtung versehen ist. Die Erfindung betrifft weiterhin ein entsprechendes Schraubelement sowie eine Rohranschlusseinrichtung für den Anschluss von Rohrleitungen mit einem Schraubelement.

Verfahren der vorstehend beschriebenen Art sowie entsprechende Schraubelemente und Rohranschlusseinrichtungen sind aus der Praxis in unterschiedlichen Ausgestaltungen bekannt. Dabei sind die Schraubelemente häufig als Schraubfittings ausgebildet, mit denen eine Rohrleitung, insbesondere eine Kraftfahrzeugrohrleitung an ein Anschlusselement angeschlossen wird. Die Rohrleitungen werden beispielsweise für Bremsflüssigkeiten in Kraftfahrzeugen eingesetzt.

Es ist bereits bekannt, die Schraubelemente bzw. Schraubfittings mit speziellen Beschichtungen zu versehen, um die Reibwerte zu beeinflussen. So ist es bekannt, dass die Beschichtung des Gewindes des Schraubfittings einen höheren Reibwert aufweist als eine Beschichtung der gewindefreien Kontaktflächen des Schraubfittings, beispielsweise an der Unterseite des Schraubenkopfes und/oder an dem Stirnende des Schraubfittings. Durch die Beschichtung mit hohem Reibwert im Bereich des Gewindes soll ein unbeabsichtigtes Lösen der Schraubverbindung erschwert werden. Die Beschichtung mit niedrigerem Reibwert im Bereich der gewindefreien Kontaktflächen verringert dagegen die Übertragung von Torsionskräften auf die zu verbindenden Teile bzw. Rohrenden. Dadurch kann eine Torsion der Rohrleitung beim Verschrauben und ein dadurch erzeugtes Rückdrehmoment vermieden werden, das zu einem unerwünschten Lockern der Schraubverbindung führen könnte. Ein Verfahren zur Erzeugung unterschiedlicher Beschichtungen mit unterschiedlichen Reibwerten auf Schraubelementen ist aus der EP 3 555 512 A1 bekannt.

Bei den bislang bekannten Beschichtungsmaßnahmen für derartige Schraubelemente stehen insbesondere nasschemische Verfahren bzw. galvanotechnische Verfahren im Vordergrund. Diese Verfahren haben den Nachteil, dass die Reibwerte der aufgebrachten Beschichtungen von Schraubelement zu Schraubelement verhältnismäßig stark variieren können. Das macht zeit- und kostenaufwändige Tests erforderlich, um festzustellen, ob die Schraubelemente den durch die Normen vorgegebenen Anforderungen entsprechen. Bei diesen bekannten Maßnahmen kann die Beschichtung oftmals auch nicht ausreichend homogen über die beschichtete Fläche aufgebracht werden. Es sind unterschiedliche Reibwerte über die beschichtete Fläche zu beobachten. Es versteht sich, dass dies nicht wünschenswert ist.

Demgegenüber liegt der Erfindung das technische Problem zugrunde, ein Verfahren der eingangs genannten Art anzugeben, mit dem die vorstehend beschriebenen Nachteile effektiv vermieden werden können. Der Erfindung liegt weiterhin das technische Problem zugrunde, ein entsprechendes Schraubelement und eine entsprechende Rohranschlusseinrichtung anzugeben.

Zur Lösung dieses technischen Problems lehrt die Erfindung ein Verfahren zur Beschichtung eines Schraubelementes, insbesondere eines Schraubelementes für den Anschluss von Rohrleitungen, vorzugsweise von Kraftfahrzeugrohrleitungen, wobei das Schraubelement zumindest ein Gewinde aufweist sowie zumindest eine gewindefreie Kontaktfläche aufweist, wobei das Gewinde zumindest bereichsweise mit einer ersten Beschichtung versehen ist und wobei die gewindefreie Kontaktfläche zumindest bereichsweise mit einer zweiten Beschichtung versehen ist, wobei sowohl die erste Beschichtung des Gewindes als auch die zweite Beschichtung der gewindefreien Kontaktfläche bzw. der gewindefreien Kontaktflächen durch Plasmabeschichtung auf das Gewinde bzw. auf die gewindefreie Kontaktfläche(en) aufgebracht wird. - Nach einer empfohlenen Ausführungsform der Erfindung wird das Gewinde über zumindest 80 %, vorzugsweise über zumindest 85 % der Gewindefläche mit der ersten Beschichtung versehen. Es empfiehlt sich, dass eine gewindefreie Kontaktfläche des Schraubelementes über zumindest 80 %, vorzugsweise über zumindest 85 % der Kontaktfläche mit der zweiten Beschichtung versehen wird.

Der Erfindung liegt die Erkenntnis zugrunde, dass durch Aufbringen der ersten Beschichtung und der zweiten Beschichtung durch ein Plasmaverfahren die Reibwerte der beschichteten Bereiche des Schraubelementes reproduzierbar eingestellt werden können und die Reibwerte der betreffenden Flächen für nacheinander beschichtete Schraubelemente nahezu konstant sind. Der Erfindung liegt weiterhin die Erkenntnis zugrunde, dass die erste und die zweite Beschichtung über die jeweilige beschichtete Fläche sehr homogen aufgebracht werden können. Die Reibwerte sind über die beschichtete Fläche nahezu konstant.

Es liegt im Rahmen der Erfindung, dass die erste Beschichtung einen Reitbwert µ1 aufweist und die zweite Beschichtung einen Reibwert µ2 aufweist und dass der erste Reibwert µ1 größer ist als der zweite Reibwert µ2. Nach besonders bevorzugter Ausführungsform der Erfindung beträgt der erste Reibwert µ1 zumindest das Doppelte, vorzugsweise zumindest das Dreifache und besonders bevorzugt zumindest das Vierfache des zweiten Reibwertes µ2.

Gemäß bewährter Ausführungsform der Erfindung beträgt die Schichtdicke der ersten Beschichtung 1 µm bis 25 µm und insbesondere 2 µm bis 20 µm. Empfohlenermaßen beträgt die Schichtdicke der zweiten Beschichtung 5 µm bis 100 µm und insbesondere 5 µm bis 50 µm.

Gemäß einer besonders bevorzugten Ausführungsform der Erfindung wird die erste Beschichtung mit dem Reibwert µ1 lediglich auf das Gewinde aufgebracht und die zweite Beschichtung mit dem Reibwert µ2 wird lediglich auf die zumindest eine gewindefreie Kontaktfläche aufgebracht. Bei dieser Ausführungsform wird also die erste Beschichtung lediglich auf das Gewinde und nicht auf die zumindest eine gewindefreie Kontaktfläche aufgebracht und die zweite Beschichtung wird lediglich auf die zumindest eine gewindefreie Kontaktfläche aufgebracht.

Nach einer anderen Ausführungsform des erfindungsgemäßen Verfahrens wird die erste Beschichtung mit dem Reibwert µ1 sowohl auf das Gewinde als auch auf die zumindest eine gewindefreie Kontaktfläche aufgebracht und die zweite Beschichtung mit dem Reibwert µ2 wird auf die zumindest eine gewindefreie Kontaktfläche - die erste Beschichtung dort überdeckend - aufgebracht. Bei dieser Ausführungsform wird also zunächst das gesamte Schraubelement oder zumindest das Gewinde und die zumindest eine gewindefreie Kontaktfläche des Schraubelementes mit der ersten Beschichtung versehen und dann wird die zweite Beschichtung im Bereich der gewindefreien Kontaktfläche bzw. im Bereich der gewindefreien Kontaktflächen auf die erste Beschichtung aufgebracht, so dass die zweite Beschichtung die Außenoberfläche an der gewindefreien Kontaktfläche bzw. an den gewindefreien Kontaktflächen bildet.

Eine besonders bevorzugte Ausführungsform, der im Rahmen der Erfindung ganz besondere Bedeutung zukommt, ist dadurch gekennzeichnet, dass als Schraubelement ein Schraubenbolzen bzw. ein Schraubfitting eingesetzt wird, der ein als Außengewinde ausgebildetes Gewinde aufweist, dass zumindest bereichsweise mit der ersten Beschichtung versehen ist. Es liegt im Rahmen der Erfindung, dass das Stirnende des Schraubfittings eine gewindefreie Kontaktfläche aufweist, die zumindest bereichsweise mit der zweiten Beschichtung versehen ist. Es liegt weiterhin im Rahmen der Erfindung, dass eine gewindeseitige Unterseite eines Schraubenkopfes des Schraubfittings eine gewindefreie Kontaktfläche aufweist, die zumindest bereichsweise mit der zweiten Beschichtung versehen ist.

Erfindungsgemäß wird sowohl die erste Beschichtung als auch die zweite Beschichtung durch Plasmabeschichtung aufgebracht. Eine besonders empfohlene Ausführungsform der Erfindung ist dadurch gekennzeichnet, dass die Plasmabeschichtung für die erste Beschichtung und/oder für die zweite Beschichtung bei Normaldruck bzw. bei Atmosphärendruck durchgeführt wird. Grundsätzlich könnte die Plasmabeschichtung auch bei anderen Drücken erfolgen, beispielsweise im Vakuum. - Es liegt im Rahmen der Erfindung, dass die Plasmabeschichtung als physikalische Gasphasenabscheidung oder als chemische Gasphasenabscheidung durchgeführt wird.

Zweckmäßigerweise wird für die Plasmabeschichtung eine Plasmabeschichtungs-Vorrichtung eingesetzt und das Material für die erste Beschichtung und/oder das Material für die zweite Beschichtung wird der Plasmabeschichtungs-Vorrichtung pulverförmig zugeführt. Es liegt im Rahmen der Erfindung, dass das Material für die erste Beschichtung und/oder das Material für die zweite Beschichtung in der Plasmabeschichtungs-Vorrichtung in die Gasphase überführt wird und anschließend in fester Form auf dem Gewinde und/oder auf der zumindest einen gewindefreien Kontaktfläche abgeschieden wird.

Es hat sich bewährt, dass die zu beschichtende Oberfläche des Gewindes und/oder der zumindest einen gewindefreien Kontaktfläche vor der Beschichtung gereinigt wird und vorzugsweise mit Hilfe der Plasmabeschichtungs-Vorrichtung gereinigt wird bzw. mittels eines Plasmastrahls gereinigt wird. Anschließend erfolgt dann die Beschichtung mit der ersten Beschichtung und/oder mit der zweiten Beschichtung.

Es empfiehlt sich, dass für die erste Beschichtung und/oder für die zweite Beschichtung zumindest ein Material bzw. zumindest eine Substanz aus der Gruppe "Metall, Metallsalz, Polymer" eingesetzt wird. Grundsätzlich kann die mittels Plasmabeschichtung aufzubringende erste Beschichtung und/oder zweite Beschichtung aus verschiedenen organischen und/oder metall-organischen Verbindungen und/oder Mischungen davon bestehen bzw. im Wesentlichen bestehen. - Zweckmäßigerweise weist die erste Beschichtung ein Metalloxid als Metallsalz auf, beispielsweise Aluminiumoxid und/oder Eisenoxid. - Als Polymere kommen im Rahmen der Erfindung insbesondere Polyolefine, Polyimide, Fluorpolymere und Polyamide infrage. - Gemäß einer Ausführungsvariante weist die erste Beschichtung ein Polyamid und/oder ein Polyimid als Polymer auf.

Zweckmäßigerweise weist die zweite Beschichtung ein den Reibwert der Beschichtung erniedrigendes Gleitmittel auf. Dabei handelt es sich vorzugsweise um ein Fluorpolymere, insbesondere um ein Polytetrafluorethylen (PTFE) und/oder um Molybdänsulfid (MoS₂). - Nach einer Ausführungsform der Erfindung weist die erste Beschichtung und/oder die zweite Beschichtung zumindest ein Material bzw. zumindest eine Substanz aus der Gruppe "Polyolefin, Polyimid, Polyamid, Fluorpolymer, Metall, Metallsalz" auf.

Gegenstand der Erfindung ist auch ein Schraubelement, insbesondere für den Anschluss von Rohrleitungen und vorzugsweise für den Anschluss von Kraftfahrzeugrohrleitungen, wobei das Schraubelement zumindest ein Gewinde aufweist sowie zumindest eine gewindefreie Kontaktfläche aufweist, wobei das Gewinde zumindest bereichsweise mit einer ersten Beschichtung versehen ist, wobei die zumindest eine gewindefreie Kontaktfläche zumindest bereichsweise mit einer zweiten Beschichtung versehen ist und wobei sowohl die erste Beschichtung des Gewindes als auch die zweite Beschichtung der zumindest einen gewindefreien Kontaktfläche durch Plasmabeschichtung aufgebracht ist. Bei dem Schraubelement handelt es sich nach besonders empfohlener Ausführungsform der Erfindung um einen Schraubfitting mit einem Außengewinde. Dieses Gewinde ist zumindest bereichsweise mit der ersten Beschichtung beschichtet.

Gegenstand der Erfindung ist weiterhin eine Rohranschlusseinrichtung für den Anschluss von Rohrleitungen, insbesondere von Kraftfahrzeugrohrleitungen, mit einem Schraubelement, wobei an das Schraubelement eine Rohrleitung angeschlossen ist und wobei das Schraubelement an ein Anschlusselement durch Verschraubung angeschlossen ist. Das Schraubelement ist erfindungsgemäß beschichtet. Zweckmäßigerweise ist das Schraubelement der erfindungsgemäßen Rohranschlusseinrichtung ein Schraubfitting mit einer Axialbohrung, welche Axialbohrung von einer Rohrleitung durchfasst wird, wobei die Rohrleitung an ihrem Rohrleitungsende einen Bördel aufweist und wobei die mit der zweiten Beschichtung versehene gewindefreie Kontaktfläche an dem Stirnende des Schraubfittings an der Bördelrückseite des Bördels anliegt. Die gewindefreie Kontaktfläche an dem Stirnende des Schraubfittings ist mit der zweiten Beschichtung versehen und liegt mit dieser zweiten Beschichtung an der Bördelrückseite des Bördels der Rohrleitung an.

Der Erfindung liegt die Erkenntnis zugrunde, dass mit dem erfindungsgemäßen Verfahren Schraubelemente mit zwei unterschiedlichen Beschichtungen mit jeweils definiert eingestelltem Reibwert reproduzierbar erzeugt werden können. Es hat sich herausgestellt, dass nacheinander mittels der erfindungsgemäßen Plasmabeschichtung beschichtete Schraubelemente kaum Abweichungen in den Reibwerten der beiden Beschichtungen aufweisen. Dadurch können zeit- und kostenaufwändige Tests entfallen um festzustellen, ob die einzelnen Schraubelemente den Anforderungen im Hinblick auf die Reibwerte entsprechen. Der Erfindung liegt weiterhin die Erkenntnis zugrunde, dass die mittels der erfindungsgemäßen Plasmabeschichtung erzeugten unterschiedlichen Schichten jeweils sehr homogen über ihre Fläche ausgebildet sind und keine nennenswerten Variationen der Reibwerte über die beschichtete Fläche aufweisen. Bei dem erfindungsgemäßen Verfahren kann auf nasschemische und/oder galvanotechnische Verfahrensschritte vollständig verzichtet werden. Die erfindungsgemäßen Beschichtungsmaßnahmen sind auf einfache und wenig aufwändige Weise und insbesondere auch auf kostengünstige Weise durchführbar.

Nachfolgend wird die Erfindung anhand einer lediglich ein Ausführungsbeispiel darstellenden Zeichnung näher erläutert. Es zeigen in schematischer Darstellung:
- Figur 1:: Einen Längsschnitt durch ein als Schraubfitting ausgebildetes erfindungsgemäßes Schraubelement,
- Figur 2:: eine Rohranschlusseinrichtung mit dem Schraubfitting gemäß Figur 1 und angeschlossener Rohrleitung und
- Figur 3:: eine schematische Darstellung einer Plasmabeschichtungs-Vorrichtung zur Durchführung des erfindungsgemäßen Verfahrens.

Die Figuren zeigen ein als Schraubfitting 1 ausgebildetes erfindungsgemäßes Schraubelement, dass vorzugsweise und im Ausführungsbeispiel für den Anschluss einer Rohrleitung 2 vorgesehen ist. Bei der Rohrleitung 2 handelt es sich insbesondere um eine Kraftfahrzeugrohrleitung. Der Schraubfitting 1 weist ein Gewinde 3 sowie gewindefreie Kontaktflächen 4 und 5 auf. Die gewindefreie Kontaktfläche 4 ist am Stirnende des Schraubfittings 1 angeordnet und die gewindefreie Kontaktfläche 5 ist an der gewindeseitigen Unterseite des Schraubenkopfes 6 des Schraubfittings 1 angeordnet.

Das Gewinde 3 bzw. das Außengewinde des Schraubfittings 1 ist vorzugsweise und im Ausführungsbeispiel vollständig mit einer ersten Beschichtung 7 versehen. Die beiden gewindefreien Kontaktflächen 4, 5 sind bevorzugt und im Ausführungsbeispiel vollständig mit einer zweiten Beschichtung 8 versehen. Der Reibwert µ1 der ersten Beschichtung 7 ist größer als der zweite Reibwert µ2 der zweiten Beschichtung 8. Vorzugsweise und im Ausführungsbeispiel beträgt der erste Reibwert µ1 zumindest das Fünffache des zweiten Reibwertes µ2. - Bevorzugt und im Ausführungsbeispiel besteht der Schraubfitting 1 aus Metall bzw. im Wesentlichen aus Metall.

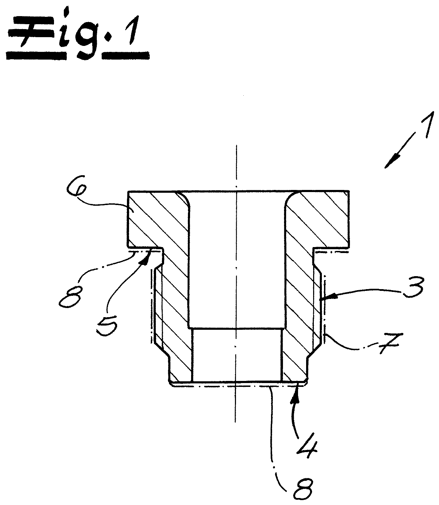

Bei der in Fig. 1 dargestellten bevorzugten Ausführungsform des Schraubfittings 1 ist die erste Beschichtung 7 mit dem höheren Reibwert µ1 im Bereich des Gewindes 3 mittels Plasmabeschichtung aufgebracht worden. Die erste Beschichtung 7 bildet im Bereich des Gewindes 3 die Außenoberfläche des Schraubfittings 1. Die zweite Beschichtung 8 mit dem niedrigeren Reibwert µ2 wurde im Bereich der gewindefreien Kontaktflächen 4 und 5 mittels Plasmabeschichtung aufgebracht. Die zweite Beschichtung 8 bildet im Bereich dieser gewindefreien Kontaktflächen 4 und 5 die Außenoberfläche des Schraubfittings 1.

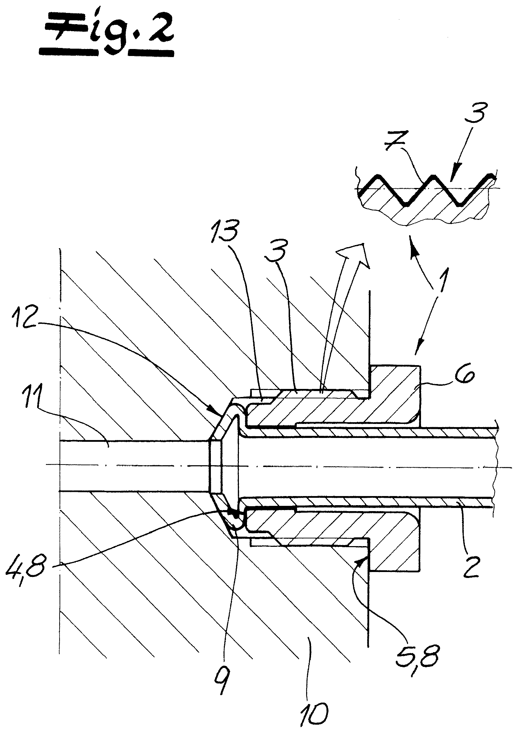

Die Fig. 2 zeigt einen erfindungsgemäß erzeugten Schraubfitting 1 im Betriebszustand bzw. eine erfindungsgemäße Rohranschlusseinrichtung mit dem Schraubfitting 1. Die Rohrleitung 2 durchfasst bevorzugt und im Ausführungsbeispiel den Schraubfitting 1 in axialer Richtung und diese Rohrleitung 2 weist an einem Ende ein Stirnelement auf, dass empfohlenermaßen und im Ausführungsbeispiel als Bördel 9 ausgebildet ist. Es liegt im Rahmen der Erfindung, dass es sich um einen metallischen Bördel 9 handelt, der vorzugsweise und im Ausführungsbeispiel einstückig an das Rohrleitungsende angeformt ist. Der Schraubfitting 1 ist im Ausführungsbeispiel nach Fig. 2 in ein als Anschlussblock 10 ausgebildetes Anschlusselement eingeschraubt. Der Anschlussblock 10 weist zweckmäßigerweise und im Ausführungsbeispiel eine integrierte zweite Rohrleitung 11 auf. Der Schraubfitting 1 drückt den Bördel 9 mit seiner stirnseitigen Dichtfläche 12 an eine Anschlussfläche des Anschlussblocks 10. Der Schraubfitting 1 wird dazu mit seinem Gewinde 3 bzw. mit seinem Außengewinde in die Sackbohrung 13 des Anschlussblocks 10 eingeschraubt. Die Sackbohrung 13 weist im Ausführungsbeispiel ein entsprechendes komplementäres Innengewinde auf. Das Gewinde 3 bzw. das Außengewinde des Schraubfittings 1 ist mit der ersten Beschichtung 7 versehen, die erfindungsgemäß durch Plasmabeschichtung aufgebracht wurde. Die gewindefreie Kontaktfläche 4 am Stirnende des Schraubfittings weist die zweite Beschichtung 8 auf, die ebenfalls mittels Plasmabeschichtung aufgebracht wurde. Die gewindefreie Kontaktfläche 5 an der gewindeseitigen Unterseite des Schraubenkopfes 6 ist ebenfalls mit der zweiten Beschichtung 8 versehen, die auch hier mittels Plasmabeschichtung aufgebracht wurde.

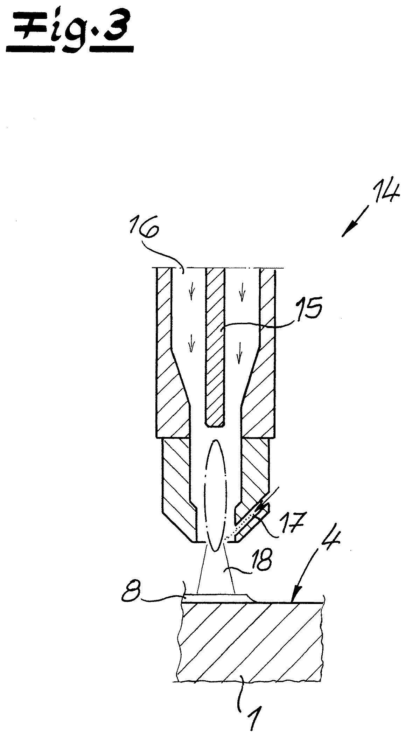

Die Fig. 3 zeigt eine für das erfindungsgemäße Verfahren geeignete Plasmabeschichtungs-Vorrichtung 14. Im Ausführungsbeispiel nach Fig. 3 wird mit dieser Plasmabeschichtungs-Vorrichtung 14 die zweite Beschichtung 8 mit dem geringeren Reibwert µ2 auf die gewindefreie Kontaktfläche 4 am Stirnende des Schraubfittings 1 aufgebracht. Die Plasmabeschichtungs-Vorrichtung weist in üblicher Weise eine Elektrode 15 sowie eine Gaszuführung 16 auf. Durch den Kanal 17 wird vorzugsweise und im Ausführungsbeispiel das Material für die Beschichtung pulverförmig zugeführt. Oberhalb der zu beschichtenden Oberfläche ist der Plasmastrahl 18 erkennbar. - Es wurde bereits oben darauf hingewiesen, dass nach bevorzugter Ausführungsform die zu beschichtende Oberfläche vor der Plasmabeschichtung mit der Plasmabeschichtungs-Vorrichtung bzw. mit deren Plasmastrahl 18 gereinigt werden kann.

## Patentansprüche

1. Verfahren zur Beschichtung eines Schraubelementes für den Anschluss von Rohrleitungen (2), vorzugsweise von Kraftfahrzeugrohrleitungen, wobei das Schraubelement zumindest ein Gewinde (3) aufweist sowie zumindest eine gewindefreie Kontaktfläche (4, 5) aufweist, wobei das Gewinde (3) zumindest bereichsweise mit einer ersten Beschichtung (7) versehen ist und wobei die gewindefreie Kontaktfläche (4, 5) zumindest bereichsweise mit einer zweiten Beschichtung (8) versehen ist, **dadurch gekennzeichnet, dass** sowohl die erste Beschichtung (7) des Gewindes (3) als auch die zweite Beschichtung (8) der gewindefreien Kontaktfläche (4, 5) durch Plasmabeschichtung auf das Gewinde (3) bzw. auf die gewindefreie Kontaktfläche (4, 5) aufgebracht wird, dass die erste Beschichtung (7) einen Reibwert µ1 aufweist und die zweite Beschichtung (8) einen Reibwert µ2 aufweist und dass der erste Reibwert µ1 größer ist als der zweite Reibwert µ2.

2. Verfahren nach Anspruch 1, wobei der erste Reibwert µ1 zumindest das Doppelte, vorzugsweise zumindest das Dreifache des zweiten Reibwertes µ2 beträgt.

3. Verfahren nach einem der Ansprüche 1 oder 2, wobei die Schichtdicke der ersten Beschichtung 1 µm bis 25 µm, insbesondere 2 µm bis 20 µm beträgt und/oder wobei die Schichtdicke der zweiten Beschichtung 5 µm bis 100 µm, insbesondere 5 µm bis 50 µm beträgt.

4. Verfahren nach einem der Ansprüche 1 bis 3, wobei als Schraubelement ein Schraubenbolzen bzw. ein Schraubfitting (1) eingesetzt wird, der ein als Außengewinde ausgebildetes Gewinde (3) aufweist, das zumindest bereichsweise mit der ersten Beschichtung (7) versehen ist.

5. Verfahren nach Anspruch 4, wobei das Stirnende des Schraubfittings (1) eine gewindefreie Kontaktfläche (4) aufweist, die zumindest bereichsweise mit der zweiten Beschichtung (8) versehen ist und/oder wobei eine gewindeseitige Unterseite eines Schraubenkopfes (6) des Schraubfittings (1) eine gewindefreie Kontaktfläche (5) aufweist, die zumindest bereichsweise mit der zweiten Beschichtung versehen ist.

6. Verfahren nach einem der Ansprüche 1 bis 5, wobei die Plasmabeschichtung für die erste Beschichtung (7) und für die zweite Beschichtung (8) bei Normaldruck bzw. bei Atmosphärendruck durchgeführt wird.

7. Verfahren nach einem der Ansprüche 1 bis 6, wobei die Plasmabeschichtung als physikalische Gasphasenabscheidung und/oder als chemische Gasphasenabscheidung durchgeführt wird.

8. Verfahren nach einem der Ansprüche 1 bis 7, wobei für die Plasmabeschichtung eine Plasmabeschichtungs-Vorrichtung (14) eingesetzt wird und wobei das Material für die erste Beschichtung (7) und/oder das Material für die zweite Beschichtung (8) der Plasmabeschichtungs-Vorrichtung (14) pulverförmig zugeführt wird.

9. Verfahren nach einem der Ansprüche 1 bis 8, wobei das Material für die erste Beschichtung (7) und/oder das Material für die zweite Beschichtung (8) in der Plasmabeschichtungs-Vorrichtung (14) in die Gasphase überführt wird und anschließend in fester Form auf dem Gewinde (3) bzw. auf der gewindefreien Kontaktfläche (4, 5) abgeschieden wird.

10. Verfahren nach einem der Ansprüche 1 bis 9, wobei für die erste Beschichtung und/oder die zweite Beschichtung zumindest ein Material aus der Gruppe "Metall, Metallsalz, Polymer" eingesetzt wird.

11. Schraubelement für den Anschluss von Rohrleitungen (2), insbesondere von Kraftfahrzeugrohrleitungen, - insbesondere hergestellt nach einem Verfahren gemäß einem der Ansprüche 1 bis 10 -, wobei das Schraubelement zumindest ein Gewinde (3) aufweist sowie zumindest eine gewindefreie Kontaktfläche (4, 5 ) aufweist, wobei das Gewinde (3) zumindest bereichsweise mit einer ersten Beschichtung (7) versehen ist und wobei die gewindefreie Kontaktfläche (4, 5) zumindest bereichsweise mit einer zweiten Beschichtung (8) versehen ist, **dadurch gekennzeichnet, dass** sowohl die erste Beschichtung (7) des Gewindes (3) als auch die zweite Beschichtung (8) der gewindefreien Kontaktfläche (4, 5) durch Plasmabeschichtung aufgebracht ist, dass die erste Beschichtung (7) einen Reibwert µ1 aufweist und die zweite Beschichtung (8) einen Reibwert µ2 aufweist und dass der erste Reibwert µ1 größer ist als der zweite Reibwert µ2.

12. Rohranschlusseinrichtung für den Anschluss von Rohrleitungen, insbesondere von Kraftfahrzeugrohrleitungen, mit einem Schraubelement hergestellt nach einem Verfahren nach einem der Ansprüche 1 bis 10 oder mit einem Schraubelement nach Anspruch 11, wobei an das Schraubelement eine Rohrleitung (2) angeschlossen ist und wobei das Schraubelement an ein Anschlusselement durch Verschraubung angeschlossen ist.

13. Rohranschlusseinrichtung nach Anspruch 12, **dadurch gekennzeichnet, dass** das Schraubelement ein Schraubfitting (1) mit einer Axialbohrung ist, welche Axialbohrung von einer Rohrleitung (2) durchfasst wird, wobei die Rohrleitung (2) an ihrem Rohrleitungsende einen Bördel (9) aufweist und dass die mit der zweiten Beschichtung (8) versehene gewindefreie Kontaktfläche (4) an dem Stirnende des Schraubfittings (1) an der Bördelrückseite des Bördels (9) anliegt.

14. Verwendung eines Schraubelementes nach Anspruch 11 oder einer Rohranschlusseinrichtung nach einem der Ansprüche 12 oder 13 im Kraftfahrzeugbau, vorzugsweise für Kraftstoffleitungen oder Hydraulikleitungen, insbesondere für Bremsleitungen.

## Claims

1. A method for coating a screw element for the connection of pipes (2), preferably of motor vehicle pipes, wherein the screw element has at least one thread (3) as well as at least one threadless contact surface (4, 5), wherein the thread (3) is at least sectionally provided with a first coating (7), and wherein the threadless contact surface (4, 5) is at least sectionally provided with a second coating (8), **characterized in that** both the first coating (7) of the thread (3) as well as the second coating (8) of the threadless contact surface (4, 5) are applied to the thread (3) or to the threadless contact surface (4, 5) via plasma coating, that the first coating (7) has a friction value µ1 and the second coating (8) a friction value µ2, and that the first friction value µ1 is larger than the second friction value µ2.

2. The method according to claim 1, wherein the first friction value µ1 measures at least two times, preferably at least three times, the second friction value µ2.

3. The method according to one of claims 1 or 2, wherein the layer thickness of the first coating measures 1 µm to 25 µm, in particular 2 µm to 20 µm, and/or wherein the layer thickness of the second coating measures 5 µm to 100 µm, in particular 5 µm to 50 µm.

4. The method according to one of claims 1 to 3, wherein the screw element used is a screw bolt or a screw fitting (1), which has a thread (3) designed as a male thread that is at least sectionally provided with the first coating (7).

5. The method according to claim 4, wherein the front end of the screw fitting (1) has a threadless contact surface (4), which at least sectionally is provided with the second coating (8), and/or wherein a threaded underside of a screw head (6) of the screw fitting (1) has a threadless contact surface (5), which at least sectionally is provided with the second coating.

6. The method according to one of claims 1 to 5, wherein the plasma coating for the first coating (7) and for the second coating (8) is performed at a normal pressure or at atmospheric pressure.

7. The method according to one of claims 1 to 6, wherein the plasma coating is performed by way of a physical vapor deposition and/or a chemical vapor deposition.

8. The method according to one of claims 1 to 7, wherein a plasma coating device (14) is used for plasma coating, and wherein the material for the first coating (7) and/or the material for the second coating (8) of the plasma coating device (14) is supplied in powder form.

9. The method according to one of claims 1 to 8, wherein the material for the first coating (7) and/or the material for the second coating (8) is converted into the vapor phase in the plasma coating device (14), after which it is deposited onto the thread (3) or onto the threadless contact surface (4, 5) in solid form.

10. The method according to one of claims 1 to 9, wherein at least one material from the group "metal, metal salt, polymer" is used for the first coating and/or the second coating.

11. A screw element for the connection of pipes (2), in particular of motor vehicle pipes, in particular manufactured based on a method according to one of claims 1 to 10, wherein the screw element has at least one thread (3) as well as at least one threadless contact surface (4, 5), wherein the thread (3) is at least sectionally provided with a fist coating (7), and wherein the threadless contact surface (4, 5) is at least sectionally provided with a second coating (8), **characterized in that** both the first coating (7) of the thread (3) as well as the second coating (8) of the threadless contact surface (4, 5) is applied via plasma coating, that the first coating (7) has a friction value µ1 and the second coating (8) a friction value µ2, and that the first friction value µ1 is larger than the second friction value µ2.

12. A pipe connection device for the connection of pipes, in particular of motor vehicle pipes, with a screw element manufactured based on a method according to one of claims 1 to 10 or with a screw element according to claim 11, wherein a pipe (2) is connected to the screw element, and wherein the screw element is connected to a terminal element via screwing.

13. The pipe connection device according to claim 12, **characterized in that** the screw element is a screw fitting (1) with an axial bore, with the axial bore being traversed by a pipe (2), wherein the pipe (2) has a flare (9) at its pipe end, and that the threadless contact surface (4) provided with the second coating (8) at the front end of the screw fitting (1) abuts against the rear flare side of the flare (9).

14. Use of a screw element according to claim 11 or a pipe connection device according to one of claims 12 or 13 in motor vehicle construction, preferably for fuel lines or hydraulic lines, in particular for brake lines.

## Revendications

1. Procédé de revêtement d'un élément à visser pour le raccordement de conduites (2), de préférence de conduites pour véhicule automobile, sachant que l'élément à visser comporte au moins un filetage (3), et comporte au moins une surface de contact sans filetage (4, 5), sachant que le filetage (3) est au moins par endroits doté d'un premier revêtement (7) et sachant que la surface de contact sans filetage (4, 5) est dotée au moins par endroits d'un deuxième revêtement (8), **caractérisé en ce que** tant le premier revêtement (7) du filetage (3) que le deuxième revêtement (8) de la surface de contact sans filetage (4, 5) est appliqué par revêtement au plasma sur le filetage (3) ou sur la surface de contact sans filetage (4, 5), **en ce que** le premier revêtement (7) comporte un coefficient de frottement µ1 et le deuxième revêtement (8) comporte un coefficient de frottement µ2 et **en ce que** le premier coefficient de frottement µ1 est plus grand que le deuxième coefficient de frottement µ2.

2. Procédé selon la revendication 1, sachant que le premier coefficient de frottement µ1 est au moins le double, de préférence au moins le triple du deuxième coefficient de frottement µ2.

3. Procédé selon l'une quelconque des revendications 1 ou 2, **caractérisé en ce que** l'épaisseur de couche du premier revêtement est de 1 µm à 25 µm, en particulier de 2 µm à 20 µm et/ou sachant que l'épaisseur de couche du deuxième revêtement est de 5 µm à 100 µm, en particulier de 5µm à 50 µm.

4. Procédé selon l'une quelconque des revendications 1 à 3, sachant qu'une tige filetée ou un raccord à vis (1) est utilisé comme élément à visser, qui comporte un filetage (3) constitué comme filetage extérieur, qui est doté au moins par endroits du premier revêtement (7) .

5. Procédé selon la revendication 4, sachant que l'extrémité avant du raccord à vis (1) comporte une surface de contact sans filetage (4), qui est dotée au moins par endroits du deuxième revêtement (8) et/ou sachant qu'une face inférieure côté filetage d'une tête de vissage (6) du raccord à visser (1) comporte une surface de contact sans filetage (5), qui est dotée au moins par endroits du deuxième revêtement.

6. Procédé selon l'une quelconque des revendications 1 à 5, sachant que le revêtement au plasma pour le premier revêtement (7) et pour le deuxième revêtement (8) est exécuté à pression normale ou à pression atmosphérique.

7. Procédé selon l'une quelconque des revendications 1 à 6, sachant que le revêtement au plasma est exécuté sous la forme d'un dépôt en phase gazeuse physique et/ou sous la forme d'un dépôt en phase gazeuse chimique.

8. Procédé selon l'une quelconque des revendications 1 à 7, sachant que pour le revêtement au plasma, on utilise un dispositif de revêtement au plasma (14) et sachant que le matériau pour le premier revêtement (7) et/ou le matériau pour le deuxième revêtement (8) est fourni au dispositif de revêtement au plasma (14) sous la forme pulvérulente.

9. Procédé selon l'une quelconque des revendications 1 à 8, sachant que le matériau pour le premier revêtement (7) et/ou le matériau pour le deuxième revêtement (8) est transféré dans la phase gazeuse dans le dispositif de revêtement au plasma (14) et est ensuite déposé sous la forme solide sur le filetage (3) ou sur la surface de contact sans filetage (4, 5).

10. Procédé selon l'une quelconque des revendications 1 à 9, sachant que pour le premier revêtement et/ou le deuxième revêtement, on utilise au moins un matériau du groupe, « métal, sel métallique, polymère ».

11. Elément à visser pour le raccordement de conduites (2), en particulier de conduites pour véhicule automobile, en particulier réalisé selon un procédé selon l'une quelconque des revendications 1 à 10, sachant que l'élément à visser comporte au moins un filetage (3), et comporte au moins une surface de contact (4, 5) sans filetage, sachant que le filetage (3) est doté au moins par endroits d'un premier revêtement (7) et sachant que la surface de contact (4, 5) sans filetage est dotée au moins par endroits d'un deuxième revêtement (8), **caractérisé en ce que**
tant le premier revêtement (7) du filetage (3) que le deuxième revêtement (8) de la surface de contact (4, 5) sans filetage est appliqué par revêtement au plasma, **en ce que** le premier revêtement (7) comporte un coefficient de frottement µ1 et le deuxième revêtement (8) comporte un coefficient de frottement µ2 et **en ce que** le premier coefficient de frottement 1 est plus grand que le deuxième coefficient de frottement µ2.

12. Dispositif de raccord tubulaire pour le raccordement de conduites, en particulier de conduites pour véhicule automobile, avec un élément à visser réalisé selon un procédé selon l'une quelconque des revendications 1 à 10 ou avec un élément à visser selon la revendication 11, sachant qu'une conduite (2) est raccordée à l'élément à visser et sachant que l'élément à visser est raccordé à un élément de raccord par vissage.

13. Dispositif de raccord tubulaire selon la revendication 12, **caractérisé en ce que** l'élément à visser est un raccord à visser (1) avec un alésage axial, lequel alésage axial est traversé par une conduite (2), sachant que la conduite (2) comporte un rebord (9) à son extrémité de conduite et **en ce que** la surface de contact (4) sans filetage dotée du deuxième revêtement (8) vient s'appliquer à l'extrémité avant du raccord à visser (1) à l'arrière de rebord du rebord (9).

14. Utilisation d'un élément à visser selon la revendication 11 ou d'un dispositif de raccord tubulaire selon l'une quelconque des revendications 12 ou 13 dans la construction automobile, de préférence pour des conduites de carburant ou des conduites hydrauliques, en particulier pour des conduites de freins.
